# FASCICULE DE BREVET EUROPEEN

(11) **EP 0 454 566 B1**
(45) Date de publication et mention de la délivrance du brevet: **03.07.1996**
(21) Numéro de dépôt: 91401070.7
(22) Date de dépôt: 23.04.1991
(51) Int. Cl.: H01S 3/0959, H01S 3/18, H01J 1/30, G06K 15/12, G11B 7/00

(54) **Laser compact à semi-conducteur du type à pompage électronique**
Kompakter, elektronengepumpter Halbleiterlaser
Electron-pumped compact semiconductor laser

(30) Priorité: 25.04.1990 FR 9005268
(43) Date de publication de la demande: 30.10.1991
(73) Titulaire: COMMISSARIAT A L'ENERGIE ATOMIQUE, 75015 Paris (FR)
(72) Inventeur: Labrunie, Guy, F-38330 Saint Ismier (FR); Molva, Engin, F-38000 Grenoble (FR)
(74) Mandataire: Signore, Robert

(56) Documents cités:
- EP-A- 0 119 646
- EP-A- 0 316 214
- EP-A- 0 379 325
- US-A- 3 803 510
- US-A- 3 942 132
- US-A- 4 513 308
- PATENT ABSTRACTS OF JAPAN, vol. 14, no. 95 (E-892)[4038], 21 février 1990 & JP-A-1 300 558
- SOVIET JOURNAL OF QUANTUM ELECTRONICS, vol. 10, no. 6, juin 1980, pages 693-695, New York, US; O.V. BOGDANKEVICH et al.: "Multilayer GaAs-A1As heterostructure laser pumped transversely by an electron beam"
- SOVIET JOURNAL OF QUANTUM ELECTRONICS, vol. 17, no. 9, septembre 1987, pages 1155-1156, New York, US; O.V. BOGDANKEVICH et al.: "Variable-gap A1xGa1-xAs heterostructure for an electron-beam-pumped laser"

## Description

La présente invention a pour objet un laser compact à semi-conducteur du type à pompage électronique. Elle s'applique notamment à tous types de traitement optique de l'information ; elle peut être utilisée dans les lecteurs de disques compacts (audio ou vidéo), dans les systèmes de mémoire optique, dans les imprimantes à laser ou les lecteurs de code à barres. Elle s'applique aussi à l'enregistrement optique et à l'instrumentation de laboratoire.

Trois types de lasers à semi-conducteurs, utilisant des alliages semi-conducteurs comme cavité laser, existent et se distinguent par leurs modes de génération de l'effet laser. Ce sont les diodes lasers à injection, les lasers à pompage électronique, et les lasers à pompage optique.

Les principaux produits commerciaux compacts qui existent sont les diodes lasers III-V à injection. La réalisation des diodes lasers nécessite l'utilisation de technologies complexes de dopage et de métallurgie des couches minces, qui ne sont maîtrisées que pour les semi-conducteurs de la famille des composés III-V, à base des atomes de Ga, Al, In, As, P et Sb. Le principal avantage des diodes lasers III-V est leur compacité, c'est-à-dire leur faible encombrement, de l'ordre du cm³.

Cependant, l'inconvénient majeur des diodes lasers III-V est la limitation du domaine des longueurs d'onde d'émission entre 0,6 et 1,55 micromètre, qui vient de la seule possibilité d'utilisation des matériaux III-V.

Parmi les autres types de lasers à semi-conducteur connus, les lasers à pompage électronique utilisent un bombardement électronique pour exciter le semi-conducteur. De manière classique, le pompage électronique est effectué à l'aide d'un canon à électrons. Une telle réalisation est décrite dans l'article de A. Nasibov, "Laser cathode ray tubes and their applications", SPIE vol.893 High power Laser Diodes and Applications p. 200-202 (1988).

Des lasers a pompage électronique sont également décrits dans l'article de O.V. Bogdankevich et al., "Variable-gap AlₓGa₁₋ₓAs heterostructure for an electron-beam-pumped laser", Soviet Journal of Quantum Electronics, 17 (1987) 9, pages 1155-1156 et dans la demande de brevet europeen EP-A-0 119 646.

L'avantage principal de ces lasers est la séparation des fonctions "source de pompage" et "cavité laser", qui permet d'utiliser tous les semi-conducteurs à gap direct, et en particulier ceux qui ne permettent pas l'injection directe, donc la réalisation de diodes laser à injection. L'utilisation de tous les semi-conducteurs à gap direct permet d'étendre la gamme des longueurs d'onde de l'ultraviolet à l'infrarouge.

Cependant, dans les lasers à semi-conducteur à pompage électronique, la densité de courant utilisée est de l'ordre de 10 à 100 A/cm² ; la tension d'accélération utilisée est de l'ordre de 20 à 100 kV. Ces valeurs élevées interdisent la réalisation d'un tel laser à semi-conducteur de volume réduit (de l'ordre du cm³), et compact, ayant des dimensions et des avantages comparables à ceux des diodes lasers III-V. A cause des densités d'énergie élevées, seul le mode de fonctionnement pulsé est autorisé, et leur application est limitée au laser appliqué à l'affichage.

Un but de la présente invention est la réalisation d'un laser à semi-conducteur de type à pompage électronique sous forme compacte et présentant un volume réduit (de l'odre du cm³), comparable à celui des diodes lasers III-V, et ayant les avantages spécifiques des lasers à semi-conducteur à pompage électronique.

Un autre but de la présente invention, lié aux avantages spécifiques des lasers à pompage électronique, est d'autoriser la réalisation de lasers délivrant des faisceaux lumineux dans une gamme de longueurs d'onde allant de l'ultraviolet à l'infrarouge moyen, et qui dépendent de la nature des matériaux semi-conducteurs utilisés.

L'invention permet d'atteindre ces buts, en utilisant, dans un dispositif compact, d'une part une source compacte d'électrons, d'autre part une cavité laser à semi-conducteur compacte et de structure particulière pour avoir un seuil de courant et une tension d'accélération des électrons faibles.

De manière plus précise, l'invention concerne un laser à semi-conducteur comprenant un semi-conducteur et un dispositif de pompage par bombardement électronique, le semi-conducteur étant une structure résonnante présentant un effet laser pour une densité de courant de seuil électronique inférieure à 10 A/cm² et pour une tension d'accélération des électrons inférieure à 30 kV, ce laser étant caractérisé par le fait que :
a) le semi-conducteur présente une hétérostructure comprenant suivant l'ordre établi ci-après au moins :
   - une zone d'excitation électronique ;
   - une première zone de confinement ;
   - une zone active,
   - une deuxième zone de confinement, la zone active étant disposée entre la première et la deuxième zones de confinement,
b) le dispositif de pompage par bombardement électronique est une source froide d'électrons de volume inférieure au cm³.

De préférence, la zone d'excitation électronique présente un gradient de bande interdite ("gap") décroissant.

De préférence encore, les zones de confinement présentent un gradient d'indice.

Un courant de seuil faible et une tension d'accélération faible permettent d'abaisser considérablement les densités d'énergie déposées sur le semi-conducteur. Ceci, en simplifiant l'assemblage du dispositif laser, et en utilisant une source froide d'électrons ayant un volume inférieur au cm³, permet d'obtenir un laser compact, ayant les avantages cités précédemment.

Selon une réalisation particulière de l'invention, l'hétérostructure est multiple. Elle peut être composée d'alliages à base de Cd, Zn, Mn, Hg, Te, Se, S ou autre.

Les semi-conducteurs utilisés sont du type à gap direct ; ils sont choisis par exemple parmi les composés III-V et II-VI et permettent de couvrir l'étendue de la gamme de longueurs d'onde de l'ultraviolet à l'infrarouge.

Pour obtenir des faisceaux lasers dans une grande gamme de longueurs d'onde, le semi-conducteur est préférentiellement un composé II-VI.

Le semi-conducteur se présente sous forme d'une cavité résonnante de type Fabry-Pérot, dont les miroirs sont fabriqués par clivage, et éventuellement par un dépôt de couches minces optiques dans le but de contrôler la réflectivité des miroirs. Eventuellement, la cavité résonnante peut être de type cavité distribuée, par exemple cavité à rétroaction distribuée, ou cavité à réflecteur de Bragg distribuée.

La zone active peut être constituée d'un simple puits, ou d'un puits quantique, ou d'un multi-puits quantique, ou d'un super-réseau, ou d'une combinaison de ces structures.

Le dispositif de pompage peut être choisi parmi les sources froides d'électrons à jonction PN, PIN ou Schottky, à structure métal-isolant-métal à effet tunnel, ou utilisant des matériaux ferroélectriques.

De manière préférée, on utilise des sources froides d'électrons réalisées par des techniques de microélectronique, ce qui facilite la fabrication en série des dispositifs.

Préférentiellement, le dispositif de pompage est une source froide d'électrons à cathodes émissives à micropointes.

On peut aussi utiliser avantageusement une source froide d'électrons constituée par des cathodes au silicium à jonctions PN polarisées en inverse.

Ces deux derniers types de source peuvent avoir une structure en mosaïque, matricielle, ou en matrice de mosaïques.

Selon un mode de réalisation particulier, le laser comprend :
une enceinte sous vide munie d'une fenêtre transparente pour la délivrance d'un faisceau laser, une première face de cette enceinte supportant la source froide d'électrons,
contenu dans cette enceinte, au moins un semi-conducteur apte à produire un faisceau laser,
contenue dans cette enceinte, fixée en regard de la source froide d'électrons, au moins une électrode apte à maintenir le semi-conducteur à une distance déterminée et en regard de la source froide d'électrons.

De manière avantageuse, cette électrode présente une forme apte à la focalisation sur le semi-conducteur de lignes de champ électrique en provenance de la source froide d'électrons. Cette forme peut par exemple être conique ou pyramidale, le semi-conducteur étant disposé au sommet.

Dans une réalisation particulière, le laser comprend des moyens pour la focalisation suivant un ruban des électrons en provenance de la source froide d'électrons.

Préférentiellement, ces moyens sont constitués par des écrans conducteurs disposés de part et d'autre du faisceau d'électrons et présentant une géométrie propre à la focalisation.

Avantageusement, le laser comprend un système de refroidissement qui permet en outre une régulation des paramètres du faisceau lumineux délivré. Ce système peut par exemple consister en un simple radiateur ou en un refroidisseur thermoélectrique de type à effet Peltier.

Les caractéristiques et avantages de l'invention apparaîtront mieux après la description qui suit donnée à titre explicatif et nullement limitatif. Cette description se réfère à des dessins annexés, sur lesquels :
- la figure 1A représente schématiquement une hétérostructure d'un composé II-VI utilisée comme matériau actif d'un laser conforme à l'invention et l'énergie du gap de chacune des zones de l'hétérostructure ;
- la figure 1B représente la cavité Fabry-Pérot réalisée par découpe et clivage du semi-conducteur ;
- les figures 2A et 2B représentent schématiquement une mosaïque et une matrice de cathodes à micropointes, respectivement, utilisées comme source froide d'électrons ;
- la figure 3 représente schématiquement un émetteur d'une source froide d'électrons à cathodes au silicium ;
- la figure 4 représente schématiquement une coupe d'un laser conforme à l'invention ;
- la figure 5 représente schématiquement, en éclaté, une enceinte sous vide conforme à l'invention ;
- la figure 6 représente schématiquement une vue partielle d'un laser conforme à l'invention ;
- la figure 7 représente schématiquement une coupe d'une variante de réalisation d'un laser conforme à l'invention ; et
- la figure 8 représente schématiquement une coupe d'une autre variante de réalisation d'un laser conforme à l'invention.

Conformément à l'invention, le matériau actif du laser possède une structure présentant un effet laser pour une densité de courant de seuil électronique inférieure à 10 A/cm² et pour une tension d'accélération des électrons inférieure à 10 kV.

Une hétérostructure multiple de composé II-VI (par exemple des alliages semi-conducteurs CdZnTe) répond à ces critères. Une telle structure peut être fabriquée par la technique de l'épitaxie par jet moléculaire. Un dépôt est effectué sur un substrat massif d'alliage semi-conducteur en CdZnTe ou en GaAs présentant une orientation cristalline particulière, <100> par exemple. La surface du substrat est d'environ 1 cm².

Une fois le dépôt de l'hétérostructure réalisé, le substrat est aminci et ramené à une épaisseur comprise entre 50 et 200 micromètres.

On fabrique ensuite les "allumettes", c'est-à-dire des cristaux semi-conducteurs rectangulaires dont deux faces parallèles servent de miroirs pour former la cavité résonante de type Fabry-Pérot du laser. Ces "allumettes" sont obtenues par exemple par clivage des faces miroirs et découpe à la scie du substrat hétéroépitaxié collé sur une feuille métallique souple.

Une "allumette" présente une longueur comprise entre 200 et 2000 micromètres (qui correspond à l'espacement entre deux plans de clivage) et une largeur comprise entre 50 et 2000 micromètres (espacement entre deux lignes de découpe à la scie).

Les miroirs de la cavité résonante du laser sont les faces de clivage. Sur ces dernières, on peut éventuellement déposer une ou plusieurs couches minces optiques (en Al₂O₃, SiO₂ ou tout autre matériau approprié) pour augmenter la réflectivité et éventuellement pour qu'un des deux miroirs possède un coefficient de réflexion proche de 100 %.

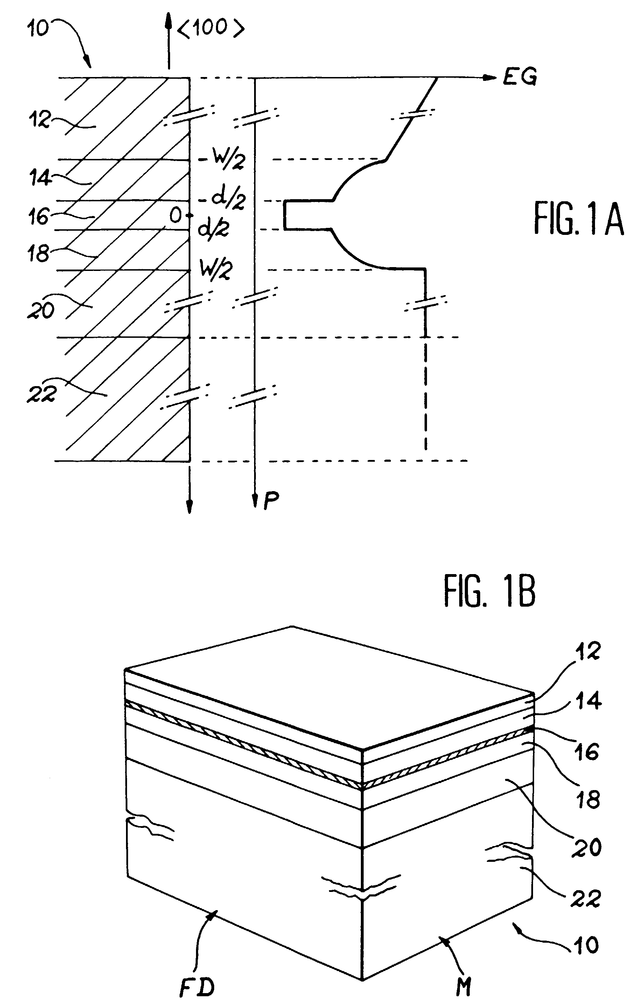

Les figures 1A et 1B représentent l'hétérostructure en couches minces du semi-conducteur 10 et l'énergie du gap EG (zone d'énergie interdite entre la bande de valence et la bande de conduction de l'alliage considéré) de chaque zone en fonction de la profondeur P. L'origine de la profondeur P est choisie au milieu de la zone active du semi-conducteur.

Dans l'exemple représenté, le semi-conducteur 10, matériau actif du laser comprend :
- une zone d'excitation électronique 12 ;
- une zone active de confinement des porteurs 16 ;
- une zone de confinement optique formée par 14, 16 et 18 ;
- une zone de couche tampon 20 ;
- le substrat 22.
   . La première zone 12 d'excitation va de la surface à une cote -w/2 ; son épaisseur est entre 0,05 et 2 micromètres.
      Dans cette zone 12, la composition du semi-conducteur correspond à la formule CdzZn1-zTe où z varie de zs (à la surface) à zw/2 (à la cote -w/2). A titre d'exemple, zs et zw/2 peuvent être égaux respectivement à 0 et 0,1. Dans cette zone 12, le gap présente une grande valeur à la surface et décroît par exemple linéairement. Elle présente un gradient décroissant du gap.
      C'est dans cette zone 12 que s'effectue la génération des paires électron-trou, créées par le bombardement électronique. Elle permet de collecter les porteurs engendrés près de la surface et de les faire migrer efficacement vers la zone active 16.
   . La seconde zone 14 est délimitée par les cotes -w/2 et -d/2 ; l'épaisseur de cette zone est par exemple de 0,05 à 0,3 micromètre. Dans cette zone 14 la composition du semi-conducteur correspond à la formule CdyZn1-yTe où y varie de zw/2 à yd/2. A titre d'exemple, yd/2 peut être entre 0,2 et 0,4. La zone 14 présente un gradient décroissant de gap. La décroissance peut être abrupte ; la composition peut passer d'une façon abrupte de zw/2 à yd/2 à la cote -w/2, et rester constante, ou au contraire décroît lentement comme c'est le cas par exemple sur la figure 1.
   . La zone active 16 est à petit gap pour le confinement des porteurs et pour la génération de la lumière laser. Cette zone 16 s'étend entre -d/2 et d/2 et a par exemple une épaisseur entre 0,002 et 0,2 micromètre. La composition de semi-conducteur dans cette zone correspond à la formule CdxZn1-xTe avec x constant et entre 0,5 et 1 par exemple.
      La zone active 16 peut être constituée d'un simple puits ou d'un puits quantique, comme c'est le cas dans la figure 1, ou d'un multi-puits quantique, ou d'un super-réseau, ou d'une combinaison de ces structures.
   . La zone 18 symétrique de la zone 14 s'étend de d/2 à w/2 et présente par exemple une épaisseur entre 0,05 et 0,3 micromètre. La composition du semi-conducteur dans cette zone correspond à la formule CdyZn1-yTe où y varie entre les valeurs yd/2 et zw/2. La zone 18 présente donc un gradient de gap croissant symétrique du gap de la zone 14. Cette croissance peut être abrupte, ou lente comme c'est le cas par exemple sur la figure 1. La zone de confinement optique de la lumière laser est constituée par l'ensemble des zones 14, 16 et 18, et a une largeur totale W, par exemple entre 0,1 et 0,6 micromètre.
   . La zone tampon 20 d'épaisseur comprise par exemple entre 0,1 et 3 micromètres est réalisée sur le substrat 22. Cette zone permet d'adapter le paramètre de maille à celui du substrat et de diminuer la densité de défauts. Elle permet également de confiner la lumière dans la zone de confinement optique. Ce peut être une simple couche, une structure multi-couches ou du type super réseau ou encore une combinaison de ces structures. Dans la réalisation représentée, la composition du semi-conducteur à l'intérieur de la zone tampon correspond à CdZnTe. Elle présente un gap plus grand que celui de la zone de confinement optique. Le substrat 22 peut être par exemple du CdZnTe ou du GaAS.

Avec les valeurs numériques énoncées ci-dessus, l'hétérostructure excitée convenablement émet un faisceau laser centré sur une longueur d'onde entre 0,55 et 0,75 micromètre.

La figure 1B représente la cavité résonante de type Fabry-Pérot. On peut voir une face FD de côté réalisée par découpe et une face M réalisée par clivage et servant de miroir pour le Fabry-Pérot.

La structure de la cavité laser, représentée à titre d'exemple sur la figure 1B, convient à un type de guidage par le gain. D'autres structures connues, de type à guidage par l'indice peuvent aussi être utilisées.

Conformément à l'invention, le semi-conducteur 10 est pompé par un bombardement électronique produit par une source froide d'électrons 23, par exemple par un réseau, c'est-à-dire une mosaïque ou une matrice ou une matrice de mosaïques, de cathodes à micropointes à émission électronique froide à effet de champ. On trouve une description d'un tel réseau et des exemples de procédés de fabrication dans les demandes de brevets français n° 86 01 024 et 87 15 432.

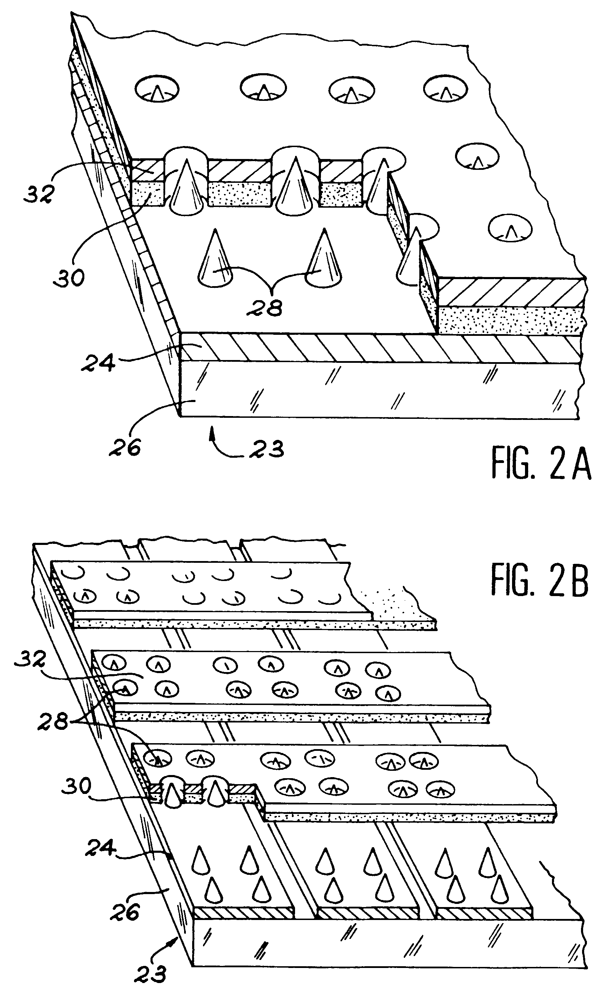

En référence à la figure 2A, on rappelle brièvement la structure d'une mosaïque de cathodes à micropointes et ses caractéristiques.

La mosaïque est constituée d'une couche conductrice 24 déposée sur un substrat 26, qui peut être isolant, par exemple en verre, ou semi-conducteur, par exemple en silicium, d'épaisseur comprise entre 0,2 et 0,5 millimètre. Cette couche conductrice est pourvue de micropointes conductrices 28.

Les micropointes ont un diamètre de base d'environ 1,5 micromètre et sont espacées par exemple de 3 ou 10 micromètres ; il y a donc par exemple entre 10 000 et 100 000 micropointes par mm². L'ensemble est recouvert d'une couche isolante 30 munie d'ouvertures laissant pointer les micropointes 28 vers l'extérieur. L'épaisseur de la couche isolante 30 est de l'ordre de 1 micromètre.

La couche isolante 30 est recouverte par une couche conductrice pourvue d'ouvertures en regard des pointes 28. Les ouvertures possèdent un diamètre d'environ 1,5 micromètre. Cette couche conductrice forme la grille d'extraction.

Lors de l'application de potentiels adéquats sur les couches conductrices 24 et 32, les micropointes 28 émettent des électrons par effet de champ.

La figure 2B représente une variante matricielle du réseau de micropointes, qu'on appelle matrice de micropointes. Dans cette structure, les couches conductrices 24 et 32 sont disposées en colonnes et lignes isolées les unes des autres. Au croisement de chaque ligne 32 et de chaque colonne 24, il peut y avoir une ou plusieurs micropointes.

Lors de l'application de potentiels adéquats sur les conducteurs de colonne 24, et les conducteurs de ligne 32, les micropointes 28 situées au croisement d'une ligne et d'une colonne portées à ces potentiels émettent des électrons. Ainsi, par application sélective de ces potentiels sur les lignes et les colonnes, on peut choisir la zone d'émission des électrons.

La densité électronique émise est fonction des valeurs des potentiels appliqués. La densité de courant peut aller de 1 à 10 mA/mm². Le courant émis est compris par exemple entre 0,1 et 5 mA. Le courant total dépend d'une part des potentiels appliqués, d'autre part du nombre et de la densité des micropointes ainsi que de la surface du réseau de micropointes.

Le réseau présente par exemple une surface rectangulaire comprise entre 0,1 et 0,5 mm².

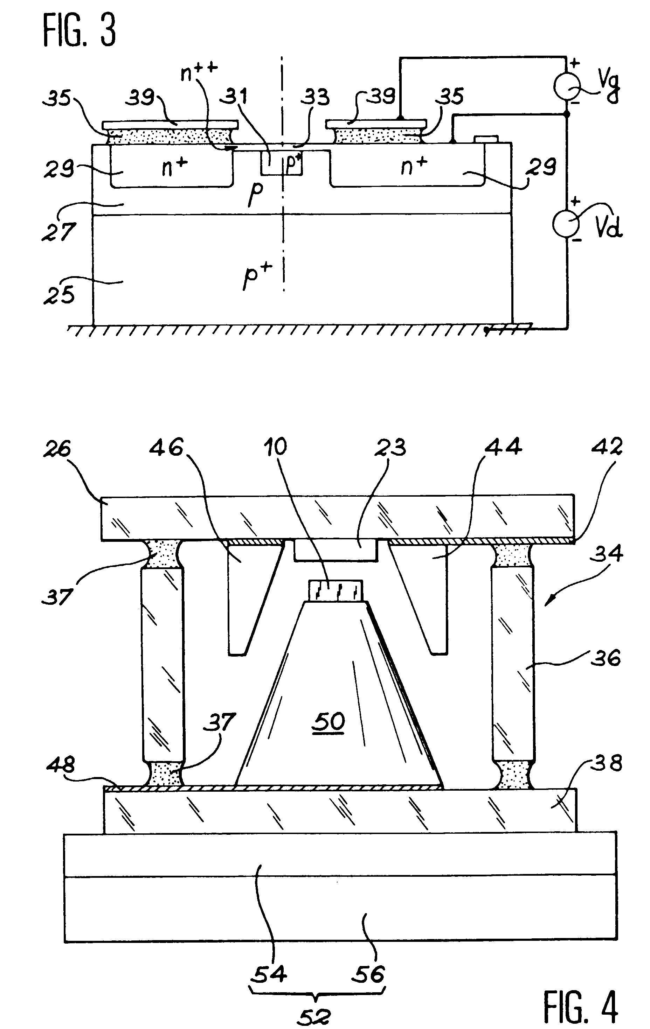

La source froide d'électrons 23 peut aussi être constituée par un réseau d'émetteurs à cathodes au silicium. La figure 3 représente schématiquement en coupe un tel émetteur. On trouve une description complète de tels émetteurs par exemple dans l'article de G.G.P. Van Gorkom et M. Moeberechts, Philips Technical Review, vol. 43, n° 3, p. 49 à 57 (1987).

Sur un substrat 25 en Si de type p⁺ et d'épaisseur 400 micromètres repose une couche épitaxiée 27 de Si de type p d'épaisseur 6 micromètres. Pour les contacts électriques, du phosphore est diffuse pour former une couche 29 de type n⁺ d'épaisseur 3 microns. La zone active 31 cylindrique, de diamètre d inférieure à 10 micromètres, de type p⁺, est réalisée par implantation de bore. Sa concentration typique est de 5 x 10¹7 cm⁻³. Sur cette zone 31, une couche n⁺⁺ très mince 33 d'épaisseur 10 nm environ, est réalisée par implantation d'arsenic ou d'antimoine. Cette couche n⁺⁺ est très dopée, typiquement 4 x 10¹⁹ cm⁻³. La zone d'émission correspondant à la jonction P-N, à l'interface des zones référencées 31 et 33, a une symétrie cylindrique, et un diamètre inférieur à 10 micromètres.

L'ensemble réalise deux diodes à jonctions P-N, constituées respectivement par les zones référencées 27, 29 et 31, 33, connectées en parallèle.

Un isolant 35, par exemple en SiO₂, d'épaisseur 1 micromètre, formant un plot cylindrique, sur lequel repose une couche conductrice 39, d'épaisseur 0,5 micromètre, par exemple en aluminium, permet d'écranter les champs électriques, de limiter le chargement de l'isolant, et de servir éventuellement comme électrode dans un système d'optique électronique.

On décrit maintenant, succinctement, un mode de fonctionnement d'une telle cathode.

On polarise les jonctions P-N en inverse, à l'aide de la tension Vd. Un très fort champ électrique, de l'ordre de 10⁶ V/cm, est créé. Ce champ fort dans la zone de déplétion de la diode réalisée par la jonction p⁺/n⁺⁺ des zones 31, 33, accélère les électrons de la zone p⁺ 31 vers la zone n⁺⁺ 33. Ces électrons "chauds" accélérés crèent un "effet d'avalanche", en créant, par collision avec les électrons de valence, d'autres paires électron-trou. Une partie des électrons (environ 1,5 %), arrivant du côte n⁺⁺ 33, ont une énergie cinétique supérieure au travail de sortie, et sont émis. Vd est typiquement entre 6 et 9 V. Le courant de la diode est de quelques mA. La densité de courant, et le courant d'émission électronique, pour un diamètre de 1 micromètre (jonction p⁺/n⁺⁺ réalisée par les couches 31, 33), sont respectivement de 1 500 A/cm² et de 10 microampères. En général, pour abaisser le travail de sortie des électrons, une couche monoatomique de césium est déposée en surface. Pour des diamètres entre 1 et 6 micromètres des zones actives 31, 33, le courant d'émission varie entre 10 microampères et 60 microampères.

Les procédés de fabrication utilisent la technologie microélectronique, et permettent de fabriquer des puces comportant plusieurs cathodes formant un réseau.

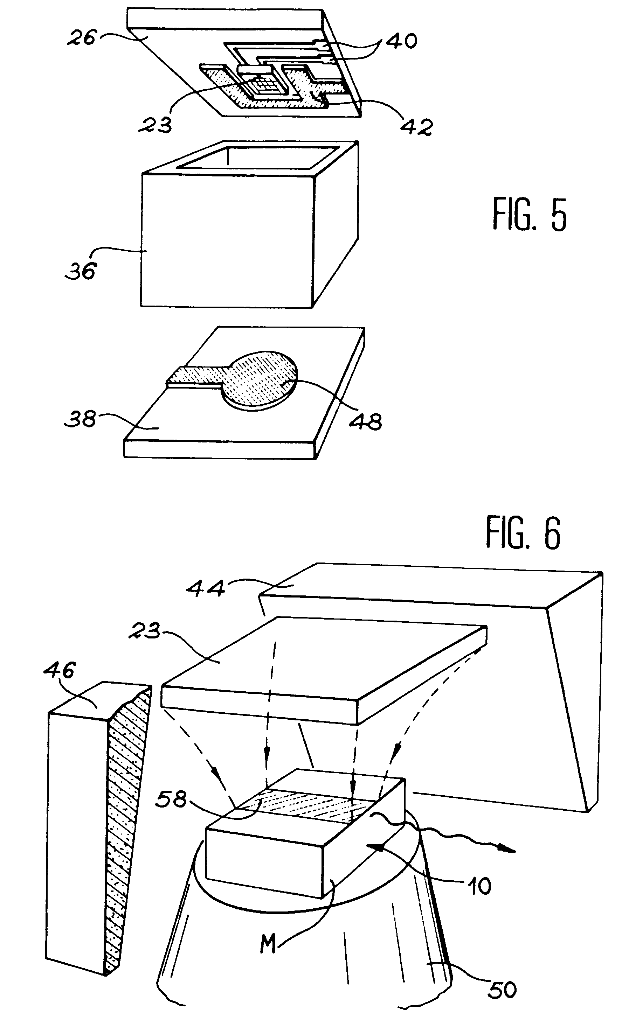

En référence aux figures 4 et 5, on décrit maintenant un exemple de réalisation d'un laser conforme à l'invention.

Le semi-conducteur 10, taillé et traité comme indiqué précédemment, est maintenu en regard de la source froide d'électrons 23, par exemple un réseau de cathodes à micropointes, à une distance déterminée, par exemple entre 1 et 10 mm. Dans cet exemple, le pompage est transversal et le semi-conducteur 10 émet un faisceau laser par l'une de ses faces parallèles au plan de la feuille, support de la figure.

L'ensemble formé par le semi-conducteur 10 et le dispositif de pompage 23 est maintenu dans une enceinte 34 sous vide secondaire. Cette enceinte 34 est réalisée par un microtube 36 par exemple à faces rectangulaires fermé en deux côtés opposés par deux plaques en matériau isolant 26, 38 en verre, par exemple.

L'enceinte 34 possède au moins une fenêtre transparente à la longueur d'onde du faisceau laser. Dans la réalisation représentée, le microtube 36 est en verre de qualité optique et joue donc le rôle de fenêtre. Les plaques 26, 38 sont soudées au microtube 36 par des soudures 37, par exemple en verre fusible, grâce à un chauffage local par laser, ou autre chauffage.

Le réseau 23 est par exemple directement réalisé sur une plaque 26. Comme on peut le voir sur la figure 5, des pistes conductrices 40, en cuivre par exemple, permettent la polarisation des conducteurs du réseau 23. Une piste conductrice supplémentaire 42 de la géométrie appropriée permet la fixation et la polarisation de moyens de focalisation 44, 46.

Sur la figure 4, on voit que la plaque 26 déborde du microtube 36 de manière à permettre un raccordement électrique sur les pistes conductrices 40, 42.

Les moyens de focalisation sont constitués par deux écrans conducteurs 44, 46, en cuivre par exemple, soudes sur la piste conductrice 42 de part et d'autre du réseau 23.

Sur la figure 5, on peut voir qu'une piste conductrice 48, par exemple en cuivre, est déposée sur l'autre plaque 38. Cette piste 48 permet la soudure d'une électrode 50, par exemple en cuivre. Cette électrode 50 maintient le semi-conducteur 10 à une distance déterminée et en regard du réseau 23.

L'électrode 50 présente une géométrie apte à la focalisation sur le semi-conducteur 10 des lignes de champ électrique en provenance du réseau 23. Dans l'exemple représenté figure 4, l'électrode 50 a la forme d'un cône ; le substrat du semi-conducteur 10 est collé à l'indium par exemple, au sommet de ce cône ; les couches épitaxiées sont donc en regard du réseau 23. L'électrode 50 peut aussi avoir la forme d'une pyramide ou toute autre forme permettant la focalisation des lignes de champ.

L'électrode 50 permet aussi l'évacuation de la chaleur emmagasinée dans le semi-conducteur 10 lors du bombardement électronique.

La plaque 38 déborde du microtube 36 de manière à permettre un raccordement électrique sur la piste 48.

Les différents éléments sont assemblés sous vide secondaire. L'ensemble est étuvé (sous vide) à une température comprise entre 150°C et 200°C. Eventuellement, la plaque 26 munie du réseau 23 et des écrans 44, 46 est étuvée séparément à plus haute température.

Les plaques 26 et 38 sont positionnées l'une par rapport à l'autre par une méthode optique.

Le laser comprend dans cet exemple de réalisation un dispositif de refroidissement 52 comportant un radiateur 54 en cuivre, d'une part en contact avec la face extérieure de la plaque 38 et d'autre part, en contact avec un refroidisseur thermoélectrique 56 miniature à effet Peltier. La température à l'intérieur de l'enceinte 34 peut être régulée mais aussi contrôlée. Or, on sait que la longueur d'onde d'émission laser dépend de la température. On peut ainsi légèrement faire varier ou stabiliser la longueur d'onde d'émission en faisant varier ou en stabilisant la température de l'enceinte 34 et du semi-conducteur 10. Le refroidissement permet également d'évacuer l'excès de chaleur qui peut être déposée par l'excitation électronique.

La figure 6 représente schématiquement une vue partielle du dispositif de la figure 4. Les écrans de focalisation 44, 46 sont disposés de part et d'autre du réseau 23 et du semi-conducteur 10. Ils présentent une géometrie adaptée à la focalisation des électrons sur un ruban 58 de la surface du semi-conducteur 10 lorsqu'ils sont portés à un potentiel adéquat. Cela permet de contrôler la largeur du ruban d'excitation, et donc de contrôler la surface et aussi la densité de courant d'excitation électronique ; ce contrôle de la focalisation permet ainsi d'obtenir des densités de courant suffisamment élevées, au-delà du seuil de génération du faisceau laser, tout en gardant des courants faibles, et d'énergie déposée faible.

Cela permet également de contrôler la largeur de la bande d'émission du faisceau lumineux et par conséquent les caractéristiques géométriques de ce dernier.

Dans la réalisation représentée, ces écrans 44, 46 sont trapézoïdaux.

On donne maintenant un exemple de valeurs numériques propres au fonctionnement d'un laser tel que celui de la figure 4.

Les micropointes sont mises à la masse. Les grilles 32 sont polarisées entre 0 et 150 V. Le potentiel de grille contrôle le courant d'électrons. L'émission des électrons est provoquée par un champ électrique d'environ 10⁷ V/cm au niveau des micropointes.

Les écrans 44, 46 sont polarisés entre -500 et +500 V. Le semi-conducteur est polarisé à une valeur de potentiel positive comprise entre 3 et 10 kV. Les lignes de champ créées par la différence de potentiel entre les grilles 32 et le semi-conducteur 10 font converger les électrons émis par les micropointes sur une surface rectangulaire du semi-conducteur 10. La cavité laser ainsi définie présente une longueur comprise entre 200 et 500 micromètres (longueur de l'"allumette" d'alliage semi-conducteur) et une largeur comprise entre 10 et 300 micromètres (avec focalisation par les écrans 44, 46). Cette largeur dépend de la focalisation du faisceau, qui dépend de la forme des écrans 44, 46, et des potentiels appliqués. Dans cet exemple, la structure de guidage est du type guidage par le gain, c'est-à-dire que la lumière laser sera confinée dans la zone définie par le ruban d'excitation 58.

Les électrons arrivant sur la surface du semi-conducteur 10 pénètrent peu dans la couche de surface (dans une épaisseur inférieure au micron). Ils créent des paires électron-trou avec un rendement maximum d'environ 30 %. Le gradient de gap (zones 12 et 14, fig. 1) fait migrer les porteurs vers la zone active (référencée 16, fig. 1) où ils sont confinés. La recombinaison des porteurs donne naissance à une lumière dont la longueur d'onde dépend des caractéristiques des alliages et de la structure constituant la zone active.

L'effet laser est obtenu pour un seuil de densité de courant inférieur à 10 A/cm². Le faisceau laser est délivré à travers une face du microtube 36.

La puissance déposée par le bombardement électronique est inférieure à quelque 10 kW/cm², dont une grande partie se transforme en chaleur. Celle-ci est évacuée par l'électrode 50 vers l'extérieur.

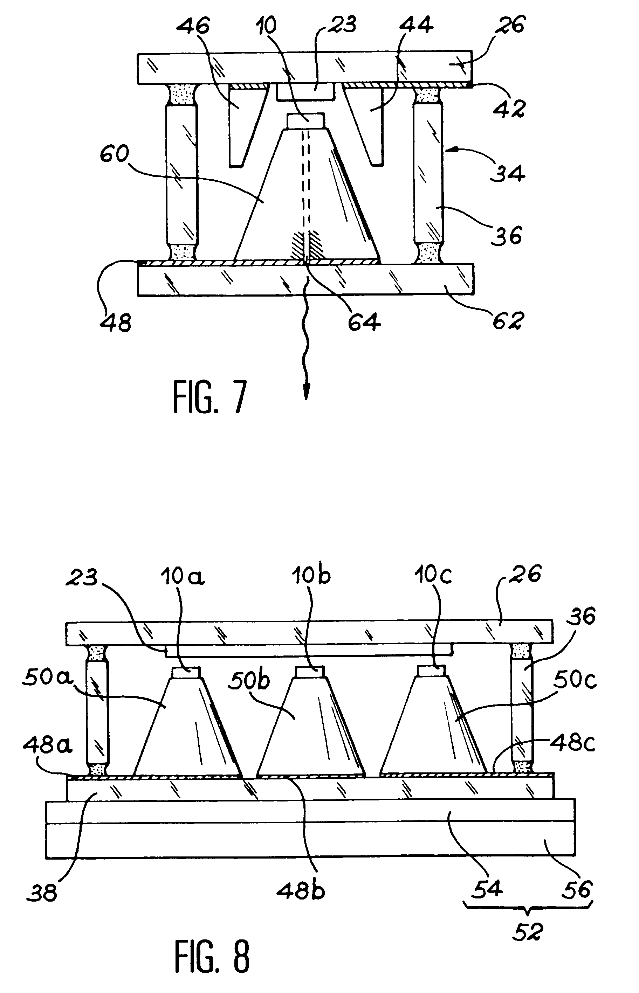

La figure 7 représente schématiquement une coupe d'un laser conforme à l'invention mais dont le pompage est longitudinal. Les composants identiques à ceux de la figure 4 portent les mêmes références.

Dans cette réalisation, l'électrode 60 qui supporte le semi-conducteur 10 est percée d'un tunnel 64 (elle peut aussi être creuse) débouchant sur la plaque 62 fermant le microtube 36. La piste conductrice 48 présente une géométrie telle qu'elle n'obture pas la sortie du tunnel 64.

La plaque 62 est en matériau isolant et transparent à la longueur d'onde du faisceau laser. Elle doit être de qualité optique.

Dans cette réalisation, les faces en regard du semi-conducteur 10 font office de miroirs réalisant la cavité résonante du laser. Les miroirs sont réalisés par des dépôts de couches minces optiques.

La figure 8 représente schématiquement en coupe une autre réalisation d'un laser conforme à l'invention. Les composants identiques à ceux de la figure 4 portent les mêmes références.

Dans cette réalisation, le laser comporte trois semi-conducteurs 10a, 10b, 10c de structures identiques ou différentes et aptes à émettre des faisceaux lasers de longueurs d'onde identiques ou différentes. Ces trois semi-conducteurs 10a, 10b, 10c sont respectivement fixés au sommet de trois électrodes 50a, 50b, 50c qui les maintiennent à une distance déterminée et en regard de la matrice 23 de cathodes à micropointes.

Grâce à la possibilité d'adressage sélectif des lignes et des colonnes d'une matrice de cathodes émissives à micropointes 23, on peut exciter l'un ou l'autre des semi-conducteurs 10a à 10c ou encore tous à la fois.

Un laser conforme à l'invention n'occupe qu'un volume réduit qui peut être de l'ordre du cm³. Il est compact et ne nécessite pas une importante alimentation électrique. L'utilisation d'un réseau de cathodes à micropointes comme dispositif de pompage autorise des utilisations continues, pulsées ou modulées. Il suffit pour cela de commander de manière adéquate les conducteurs du réseau.

L'invention ne se limite nullement aux exemples de réalisation décrits et représentés ; elle en admet toutes les variantes. On peut par exemple ajouter au laser un boîtier de protection possédant une fenêtre de sortie. On peut aussi utiliser d'autres sources froides d'électrons et d'autres procédés et matériaux d'assemblage du dispositif laser, en respectant les principes et les avantages de l'invention. Le semi-conducteur peut également être fabriqué en d'autres alliages, d'autres hétérostructures, en matériau massif ou en couches minces. La cavité peut être de type Fabry-Pérot ou distribuée, la structure de guidage peut être de type par le gain ou par l'indice. Les électrodes de focalisation et leur nombre peuvent être modifiés. Le dispositif peut fonctionner en mode continu, pulsé ou modulé, entre 77 et 300 K, ou autour de la température ambiante.

## Revendications

1. Laser à semi-conducteur comprenant un semi-conducteur (10) et un dispositif de pompage par bombardement électronique (23), le semi-conducteur (10) étant une structure résonnante présentant un effet laser pour une densité de courant de seuil électronique inférieure à 10 A/cm² et pour une tension d'accélération des électrons inférieure à 30 kV, ce laser étant caractérisé par le fait que :
a) le semi-conducteur (10) présente une hétérostructure comprenant suivant l'ordre établi ci-après au moins :
- une zone (12) d'excitation électronique ;
- une première zone (14) de confinement ;
- une zone active (16) ;
- une deuxième zone de confinement (18), la zone active (16) étant disposée entre la première et la deuxième zones de confinement (14, 18) ;
b) le dispositif de pompage (23) par bombardement électronique est une source froide d'électrons de volume inférieure au cm³.

2. Laser selon la revendication 1, caractérisé en ce que la zone d'excitation électronique (12) présente un gradient de bande interdite décroissant.

3. Laser selon la revendication 1, caractérisé en ce que les zones de confinement (14, 18) présentent un gradient d'indice.

4. Laser selon la revendication 1, caractérisé en ce qu'il comprend des moyens pour la focalisation des électrons en provenance de la source froide d'électrons (23) suivant un ruban (58) allongé selon la longueur de la structure résonnante.

5. Laser selon la revendication 4, caractérisé en ce que les moyens de focalisation sont constitués par deux écrans conducteurs (44, 46) disposés de part et d'autre de la source froide d'électrons (23) et du semi-conducteur (10) et portés à deux potentiels appropriés.

6. Laser selon la revendication 1, caractérisé en ce qu'il comprend :
- une enceinte (34) sous vide munie d'une fenêtre transparente (36) pour la délivrance d'un faisceau laser, une première paroi (26) de cette enceinte (34) supportant la source froide d'électrons,
- contenu dans cette enceinte (34), au moins un semi-conducteur (10) apte à produire un faisceau laser,
- contenue dans cette enceinte (34) fixée sur une seconde paroi (38) de l'enceinte (34) en regard de la première (26), au moins une électrode (50) apte à maintenir le semi-conducteur (10) à une distance déterminée et en regard de la source froide d'électrons (23).

7. Laser selon la revendication 6, caractérisé en ce que chaque électrode (50) présente une forme conique.

8. Laser selon la revendication 6, caractérisé en ce qu'il comprend un système de refroidissement (52).

9. Laser selon la revendication 6, caractérisé en ce qu'il comporte plusieurs semi-conducteurs (10a, 10b, 10c) supportés par autant d'électrodes (50a, 50b, 50c).

10. Laser selon l'une quelconque des revendications 1 à 9, caractérisé par le fait que la source froide d'électrons est une source à micropointes.

11. Laser selon la revendication 10, caractérisé en ce que la source froide d'électrons à micropointes (23) est du type à matrice à adressage sélectif.

## Patentansprüche

1. Halbleiterlaser, einen Halbleiter (10) und eine Elektronenbombardement-Pumpvorrichtung (23) umfassend, wobei der Halbleiter (10) eine Resonanzstruktur ist, die einen Lasereffekt aufweist für eine elektronische Schwellenstromdichte von weniger als 10 A/cm² und für eine Beschleunigungsspannung der Elektronen unter 30 kV,
**dadurch gekennzeichnet:**
a) daß der Halbleiter (10) eine Heterostruktur aufweist, die der nachfolgend erstellten Reihenfolge entsprechend wenigstens umfaßt:
a) eine Elektronenerregungszone (12);
b) eine erste Einschließungszone (14);
c) eine aktive Zone (16);
d) eine zweite Einschließungszone (18), wobei die aktive Zone (16) zwischen der ersten und der zweiten Einschließungszone (14, 18) angeordnet ist;
b) daß die Elektronenbombardement-Pumpeinrichtung (23) eine kalte Elektronenquelle mit einem Volumen kleiner als 1 cm³ ist.

2. Laser nach Anspruch 1, dadurch gekennzeichnet, daß die Elektronenerregungszone (12) einen abnehmenden Band- bzw. Energielückengradienten aufweist.

3. Laser nach Anspruch 1, dadurch gekennzeichnet, daß die Einschließungszonen (14, 18) einen Indexgradienten aufweisen.

4. Laser nach Anspruch 1, dadurch gekennzeichnet, daß er Einrichtungen zum Fokussieren der von der kalten Elektronenquelle (23) stammenden Elektronen gemäß eines entsprechend der Länge der Resonanzstruktur ausgedehnten Streifens (58) umfaßt.

5. Laser nach Anspruch 4, dadurch gekennzeichnet, daß die Fokussiereinrichtungen gebildet werden durch zwei leitende Schirme (44, 46), beiderseits der kalten Elektronenquelle (23) und des Halbleiters (10) angeordnet und an zwei geeignete Potentiale gelegt.

6. Laser nach Anspruch 1, dadurch gekennzeichnet, daß er umfaßt:
- eine Zelle (34) unter Vakuum, versehen mit einem transparenten Fenster (36) für den Austritt eines Laserstrahls, eine erste Wand (26) dieser Zelle (34), die die kalte Elektronenquelle trägt,
- enthalten in dieser Zelle (34), befestigt an einer zweiten Wand (38) der Zelle (34), der ersten (26) gegenüberstehend, wenigstens eine Elektrode (50), fähig den Halbleiter (10) mit einem bestimmten Abstand von der kalten Elektronenquelle (23) und dieser gegenüberstehend festzuhalten.

7. Laser nach Anspruch 6, dadurch gekennzeichnet, daß jede Elektrode (50) eine konische Form aufweist.

8. Laser nach Anspruch 6, dadurch gekennzeichnet, daß er ein Kühlsystem (52) umfaßt.

9. Laser nach Anspruch 6, dadurch gekennzeichnet, daß er mehrere Halbleiter (10a, 10b, 10c) umfaßt, getragen durch ebensoviele Elektroden (50a, 50b, 50c).

10. Laser nach einem der Ansprüche 1 bis 9, dadurch gekennzeichnet, daß die kalte Elektronenquelle eine Mikrospitzenquelle ist.

11. Laser nach Anspruch 10, dadurch gekennzeichnet, daß die kalte Mikrospitzenelektronenquelle (23) vom Typ mit Selektiv-Adressierungs-Matrix ist.

## Claims

1. Semiconductor laser having a semiconductor (10) and an electron bombardment pumping device (23), the semiconductor (10) being a resonant structure having a laser effect for an electronic threshold current density below 10 A/cm² and for an acceleration voltage of the electrons below 30 kV, said laser being characterized in that:
a) the semiconductor (10) has a heterostructure comprising, in the order established hereinafter, at least:
- one electronic excitation zone (12),
- one confinement zone (14),
- one active zone (16),
- one second confinement zone (18), the active zone (16) being located between the first and second confinement zones (14, 18),
b) the electron bombardment pumping device (23) being a cold electron source with a volume below 1 cm³.

2. Laser according to claim 1, characterized in that the electronic excitation zone (12) has a decreasing gap gradient.

3. Laser according to claim 1, characterized in that the optical confinement zones (14, 18) have an index gradient.

4. Laser according to claim 1, characterized in that it comprises means for focussing electrons coming from the cold electron source (23) along a ribbon (58) elongated in accordance with the length of the resonant structure.

5. Laser according to claim 4, characterized in that the focussing means are constituted by two conductive screens (44, 46) located on either side of the cold electron source (23) and the semiconductor (10) and which are raised to two appropriate potentials.

6. Laser according to claim 1, characterized in that it comprises a vacuum enclosure (34) having a transparent window (36) for supplying a laser beam, a first face (26) of said enclosure (34) supporting the cold electron source, contained in said enclosure (34), at least one semiconductor (10) able to produce a laser beam and, contained in said enclosure (34) and fixed to a second face (38) of the enclosure (34) facing the first, at least one electrode (50) able to keep a semiconductor (10) at a given distance from and facing the cold electron source (23).

7. Laser according to claim 6, characterized in that each electrode (50) has a conical shape.

8. Laser according to claim 6, characterized in that it comprises a cooling system (52).

9. Laser according to claim 6, characterized in that it has several semiconductors (10a, 10b, 10c) supported by the same number of electrodes (50a, 50b, 50c).

10. Laser according to any one of the claims 1 to 9, characterized in that the cold electron source is a microdot source.

11. Laser according to claim 10, characterized in that the microdot cold electron source (23) is of the selective addressing matrix type.
